# EUROPÄISCHE PATENTSCHRIFT

(11) **EP 0 712 161 B1**
(45) Veröffentlichungstag und Bekanntmachung des Hinweises auf die Patenterteilung: **17.03.1999**
(21) Anmeldenummer: 95117224.6
(22) Anmeldetag: 02.11.1995
(51) Int. Cl.: H01L 25/16

(54) **Halbleiterbaugruppe für die bidirektionale, leitungsungebundene, optische Datenübertragung**
Semiconductor assembly for a free space bidirectional optical transmission system
Elément semi-conducteur pour une transmission optique de données bidirectionnelle en espace libre

(30) Priorität: 10.11.1994 DE 4440088
(43) Veröffentlichungstag der Anmeldung: 15.05.1996
(73) Patentinhaber: Vishay Semiconductor GmbH, 74072 Heilbronn (DE)
(72) Erfinder: Krieger, Ralph-Jochen, D-74821 Mosbach (DE)
(74) Vertreter: Maute, Hans-Jürgen, Dipl.-Ing.

(56) Entgegenhaltungen:
- DE-A- 4 212 948
- GB-A- 1 518 089
- US-A- 5 049 973
- US-A- 5 249 245
- PATENT ABSTRACTS OF JAPAN vol. 012 no. 500 (E-699) ,27.Dezember 1988 & JP-A-63 211687 (SUMITOMO ELECTRIC IND LTD) 2.September 1988,
- PATENT ABSTRACTS OF JAPAN vol. 014 no. 461 (E-0987) ,5.Oktober 1990 & JP-A-02 186680 (NEW JAPAN RADIO CO LTD) 20.Juli 1990,

## Beschreibung

Die bidirektionale, leitungsungebundene, serielle Datenübertragung mit Hilfe von elektromagnetischen Wellen aus dem infraroten Wellenlängenbereich gewinnt immer mehr an Bedeutung. So z. B. bei der Datenübertragung zwischen einem Personalcomputer und den Peripheriebausteinen.

Für Fernsteueranwendungen sind Baugruppen auf dem Markt erhältlich und aus der DE 42 12 948 bekannt, die neben einem Infrarotempfänger auch ein Verstärker-IC, welches den Photostrom des Empfängers verstärkt, und weitere passive Bauelemente wie Kapazitäten und Widerstände enthält. Diese bekannte Baugruppe enthält also alle für den Empfang und die Auswertung der IR-Fernsteuersignale erforderlichen analogen Bauelemente. Sie ist in der Streifentechnik aufgebaut, bei der auf einem Streifenleiter alle Chips und passiven Bauelemente in einer einzigen Ebene montiert sind.

Dem Fachmann stellt sich die Aufgabe, eine Halbleiterbaugruppe für die optische Datenübertragung anzugeben, die alle dazu notwendigen Funktionen wie Senden, Empfangen und Verstärken in einem gemeinsamen Aufbau umfaßt, geringe Abmessungen aufweist und bei der die gegenseitige Beeinflussung der Chips untereinander minimiert ist.

Diese Aufgabe wird durch eine Halbleiterbaugruppe mit den Merkmalen des Anspruchs 1 gelöst. Die vorteilhafte Ausgestaltung der Halbleiterbaugruppe erfolgt gemäß den Merkmalen der abhängigen Ansprüche.

Die erfindungsgemäße Halbleiterbaugruppe besteht aus einem Sendechip, das Strahlung im IR-Bereich aussendet, einem Empfängerchip, das auf Strahlung im IR-Bereich anspricht und daraufhin einen Photostrom abgibt und einer integrierten Schaltung zum Verstärken des Photostroms des Empfängerchips. Diese drei Halbleiterchips sind auf einer Leiterstreifenanordnung mit mindestens drei Streifenteilen montiert. Die integrierte Schaltung ist auf der flachen Seitenfläche der Leiterstreifenanordnung in einer ersten Ebene, die parallel zur Längsrichtung der Leiterstreifenanordnung verläuft, angeordnet. Das Sendechip und das Empfängerchip sind in einer zweiten Ebene, die senkrecht zur ersten Ebene verläuft, an einem Ende der Streifenteile angeordnet. Durch die Kombination einer Standstreifen- und einer Flachstreifenmontagetechnik und durch die Anordnung der Bauteile in zwei senkrecht zueinanderstehenden Ebenen erhält man eine Baugruppe, deren Gehäuseabmessungen sehr klein ausgestaltet werden können. Die optisch relevanten Bauelemente sind an einem Ende, der integrierte Schaltkreis in einer optisch geschützten Seitenposition angeordnet. Das direkte Bestrahlen des integrierten Schaltkreises wird somit vermieden.

Ein erstes Streifenteil weist einen Reflektor auf, der an der Stirnseite angeformt ist. In diesem Reflektor befindet sich das Sendechip. Ein zweites Streifenteil ist an einem Ende abgewinkelt. Am abgewinkelten Teilstück ist auf der vom Streifenteil wegweisenden Oberfläche das Empfängerchip montiert.

Das obere Ende der Leiterstreifenanordnung ist mit einem Vergußkörper versehen. Der Vergußkörper ist für Strahlung im IR-Bereich durchlässig und schließt das Sendechip, das Empfängerchip und die integrierte Schaltung ein. Der Vergußkörper weist zwei kalottenförmige Ausformungen der Oberfläche auf, die so angeordnet sind, daß für das Empfängerchip und das Sendechip jeweils eine separate optische Fokussiereinrichtung entsteht. Das Gehäuse der Baugruppe ist einer Standardleuchtdiode nicht unähnlich. Die Unterschiede bestehen in der Anzahl der Streifenanschlüsse und in der Ausgestaltung des Vergußkörpers mit den beiden optischen Linsen.

Kurze Beschreibung der Figuren:
- Figur 1: zeigt die Halbleiterbaugruppe in perspektivischer Darstellung,
- Figur 2: zeigt die Halbleiterbaugruppe in der Seitenansicht,
- Figur 3: zeigt die Halbleiterbaugruppe in der Ansicht von oben.

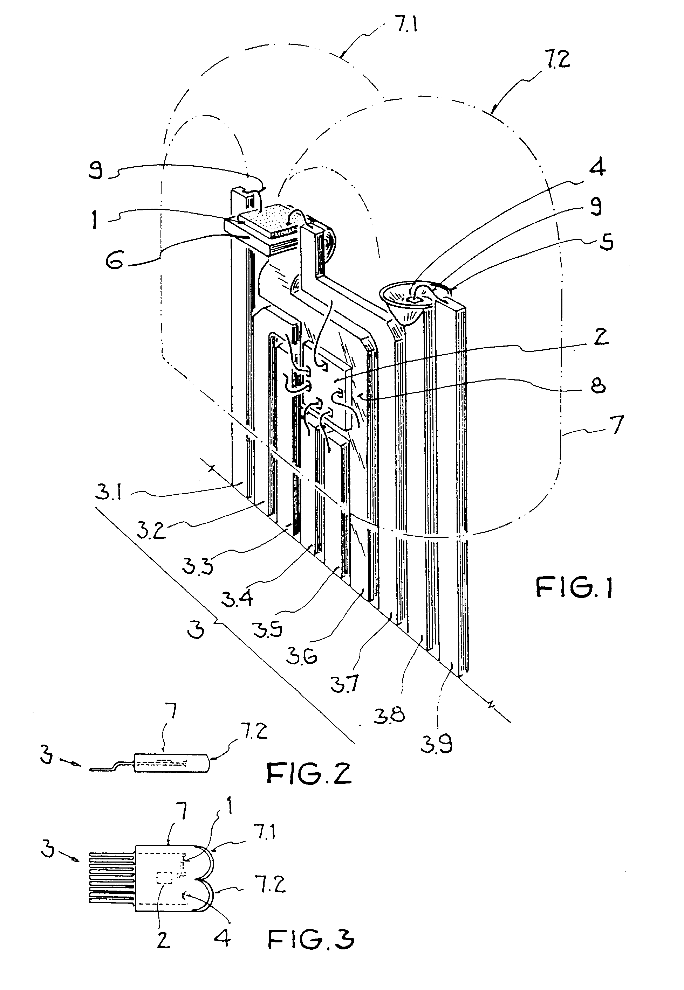

Im folgenden wird ein Ausgestaltungsbeispiel der Halbleitergruppe anhand der Figuren erläutert. Die Halbleitergruppe nach den Figuren 1 bis 3 ist auf einer Leiterstreifenanordnung 3 bestehend aus neun Streifenteilen 3.1 bis 3.9 aufgebaut. Die Leiterstreifenanordnung 3 wird üblicherweise als ein Stanzteil aus einem Kupfer-Blech mit einer Dicke von ca. 0,3 mm hergestellt. Bis nach dem Vergießen der Halbleiterbaugruppe mit einer Vergußmasse am oberen Ende der Streifen sind die Streifenteile 3.1 bis 3.9 am unteren Ende mit in den Figuren nicht dargestellten Querstegen untereinander verbunden.

Ein erstes Streifenteil 3.6 ist so ausgebildet, daß ein Montagebereich 8 im oberen Teil zum Befestigen des integrierten Schaltkreises angeordnet ist. Der integrierte Schaltkreis liegt in Chipform vor und bildet einen Verstärker für den vom Empfängerchip gelieferten Photostrom.

In seiner Verlängerung ist das erste Streifenteil 3.6 derart abgewinkelt, daß ein zweiter Montagebereich 6 entsteht. Darauf ist das Empfängerchip 1 so angeordnet, daß seine Hauptebene in einer Richtung verläuft, die senkrecht zur Montageebene des integrierten Schaltkreises angeordnet ist. Die Flächennormale der Empfangsebene des Empfängerchips weist von der Streifenanordnung weg. Es ist natürlich auch möglich das Empfängerchip auf einen eigenen Streifenteil anzuordnen. Auch in diesem Fall ist das Ende des entsprechenden Streifenteils abgewinkelt, um eine rechtwinklige Montage zum Verstärker-IC zu ermöglichen.

Ein Streifenteil 3.8 weist an seinem oberen Ende einen Reflektor 5 auf, in dessen Zentrum das Sendechip 4 in der gleichen Ebene wie das Empfängerchip 1 montiert ist. Der Reflektor 5 ist ein integraler Bestandteil des Streifenteils 3.8 und bildet dessen Stirnseite.

Die übrigen Streifenteile dienen dem elektrischen Anschluß der einzelnen Chips und integrierten Schaltkreise. Ihre Anzahl ist abhängig von den Anforderungen, die an die Halbleiterbaugruppe gestellt werden und von den Funktionen, die die Halbleiterbaugruppe umfaßt. Mit Bonddrähten 9 werden die Verbindungen zwischen den Chips und den Leiter streifen hergestellt. Die Verbindung zwischen den Chips und den Streifenteilen, auf denen sie montiert sind, kann alternativ auch durch eine Lötverbindung oder durch einen leitfähigen Klebstoff erfolgen.

Die optisch relevanten Chips werden also in einer Standstreifentechnik, das Verstärker-IC senkrecht dazu in einer Flachstreifentechnik montiert. Der integrierte Schaltkreis ist in einer optisch geschützten Position angeordnet und mit optimalen, an die Anzahl der benötigten elektrischen Verbindungen angepaßten Anschlußmöglichkeiten versehen.

Die Halbleiterbaugruppe ist mit einem Vergußkörper umgeben, der durch bei optoelektronischen Bauteilen üblichen Verfahren hergestellt werden kann. Der in den Figuren 1 bis 3 dargestellte Vergußkörper 7 läßt sich problemlos in Standardgießtechniken herstellen und entformen. Die in den Vergußkörper integrierten Optiken 7.1, 7.2 lassen sich für das Sendechip und das Empfangschip separat optimieren. Die beiden linsenförmigen Oberflächen 7.1, 7.2 sorgen außerdem dafür, daß der Sendechip nicht direkt das Empfangschip bestrahlt.

Da die optisch relevanten Chips in Standstreifentechnik an der oberen Stirnseite der Streifenanordnung angeordnet sind, fallen die resultierenden Abmessungen der fertigen Baugruppe sehr gering aus. Die Baugruppe eignet sich gerade wegen der geringen Abmessungen auch für den Einbau in einer PCMCIA-Karte für die optische Datenübertragung.

## Patentansprüche

1. Halbleiterbaugruppe mit
• einem Empfängerchip (1), das auf Strahlung im IR-Bereich anspricht und daraufhin einen Photostrom I_{PH} abgibt,
• einer integrierten Schaltung (2) zum Verstärken des Photostroms I_{PH} des Empfängerchips (1),
• einer Leiterstreifenanordnung (3) mit mindestens drei Streifenteilen, auf der Empfängerchip (1) und integrierte Schaltung (2) montiert sind,
dadurch gekennzeichnet,
• daß die Halbleiterbaugruppe ein Sendechip (4) enthält, das Strahlung im IR-Bereich aussendet,
• daß die integrierte Schaltung (2) auf einer ersten Ebene parallel zur Längsrichtung der Leiterstreifenanordnung (3) angeordnet ist,
• daß das Sendechip (4) und das Empfängerchip (1) in einer zweiten Ebene senkrecht zur ersten Ebene an einem Ende der Leiterstreifenanordnung (3) angeordnet sind.

2. Halbleiterbaugruppe nach Anspruch 1, dadurch gekennzeichnet, daß ein erstes Streifenteil (3.8) an einer Stirnseite einen angeformten Reflektor (5) aufweist, in dem das Sendechip (4) befestigt ist.

3. Halbleiterbaugruppe nach Anspruch 1 oder 2, dadurch gekennzeichnet,
- daß ein zweites Streifenteil (3.6) an einem Ende ein abgewinkeltes Teilstück (6) aufweist, und
- daß auf dem abgewinkelten Teilstück (6) das Empfängerchip (1) montiert ist.

4. Halbleiterbaugruppe nach einem der Ansprüche 1 bis 3, dadurch gekennzeichnet, daß die Leiterstreifenanordnung (3) teilweise, die integrierte Schaltung (2), das Empfängerchip (1) und das Sendechip (4) vollständig mit einem für Strahlung im IR-Bereich durchlässigen Vergußkörper (7) umschlossen sind.

5. Halbleiterbaugruppe nach Anspruch 4, dadurch gekennzeichnet, daß der Vergußkörper (7) für das Sendechip (4) und für das Empfängerchip (1) jeweils eine linsenförmige, als optisch brechendes Element ausgebildete Oberfläche (7.1, 7.2) aufweist.

## Claims

1. A semiconductor assembly comprising
- a receiving chip (1) which responds to radiation in the IR-range and then emits a photocurrent I_{PH},
- an integrated circuit (2) for amplifying the photocurrent I_{PH} of the receiving chip (1),
- a strip conductor arrangement (3) comprising at least three strip sections on which the receiving chip (1) and the integrated circuit (2) are mounted,
characterised in that
- the semiconductor assembly contains a transmitting chip (4) which transmits radiation in the IR-range,
- the integrated circuit (2) is arranged in a first plane in parallel to the longitudinal direction of the strip conductor arrangement (3),
- the transmitting chip (4) and receiving chip (1) are arranged in a second plane at right angles to the first plane at one end of the strip conductor arrangement (3).

2. A semiconductor assembly according to Claim 1, characterised in that at one end side a first strip section (3.8) comprises an integral reflector (5) in which the transmitting chip (4) is secured.

3. A semiconductor assembly according to Claim 1 or 2, characterised in that
a second strip section (3.6) comprises an angled subsection (6) at one end and
- the receiving chip (1) is mounted on the angled subsection (6).

4. A semiconductor assembly according to one of Claims 1 to 3, characterised in that the strip conductor arrangement (3) is enclosed partially, and the integrated circuit (2), receiving chip (1) and transmitting chip (4) are enclosed completely by a sealing body (7) which is permeable to radiation in the IR-range.

5. A semiconductor assembly according to Claim 4, characterised in that for the transmitting chip (4) and the receiving chip (1) the sealing body (7) in each case comprises a lens-like surface (7.1, 7.2) in the form of an optically refractive element.

## Revendications

1. Ensemble semiconducteur équipé
• d'une puce réceptrice (1), sensible à un rayonnement infrarouge et délivrant ensuite un photocourant I_{PH},
• d'un circuit intégré (2) en vue de l'amplification du photocourant I_{PH} de la puce réceptrice (1),
• d'un dispositif à bandes conductrices (3) avec au moins trois bandes partielles, qui sont montées sur la puce réceptrice (1) et le circuit intégré (2),
caractérisé en ce que,
• l'ensemble semiconducteur comporte une puce émettrice (4) émettant le rayonnement infrarouge,
• le circuit intégré (2) est disposé sur un premier plan parallèle à la direction longitudinale du dispositif à bandes conductrices (3),
• la puce émettrice (4) et la puce réceptrice (1) sont disposées dans un second plan perpendiculaire au premier plan à une extrémité du dispositif à bandes conductrices (3).

2. Ensemble semiconducteur selon la revendication 1, caractérisé en ce qu'une première bande partielle (3.8) présente sur un côté frontal un réflecteur façonné (5), dans lequel est fixée la puce émettrice (4).

3. Ensemble semiconducteur selon la revendication 1 ou 2, caractérisé en ce que,
- une seconde bande partielle (3.6) présente à une extrémité une partie coudée (6), et
- sur la partie coudée (6) est montée la puce réceptrice (1).

4. Ensemble semiconducteur selon l'une quelconque des revendications 1 à 3, caractérisé en ce que le dispositif à bandes conductrices (3) partiellement, le circuit intégré (2), la puce réceptrice (1) et la puce émettrice (4) sont complètement entourés par un surmoulage (7) transparent au rayonnement infrarouge.

5. Ensemble semiconducteur selon la revendication 4, caractérisé en ce que le surmoulage (7) pour la puce émettrice (4) et pour la puce réceptrice (1) présente respectivement une surface (7.1, 7.2) en forme de lentille réalisée sous la forme d'un élément réfringent.
